# EUROPEAN PATENT APPLICATION

(11) **EP 2 554 952 A1**
(43) Date of publication of application: **06.02.2013**
(21) Application number: 10848862.8
(22) Date of filing: 16.09.2010
(51) Int. Cl.: G01F 1/00, B81B 3/00, G01F 1/42, G01F 15/14, H01L 29/84

(54) **FLOWRATE SENSOR AND FLOWRATE DETECTION DEVICE**

(30) Priority: 30.03.2010 JP 2010077699
(71) Applicant: Kikuchi Seisakusho Co., Ltd., Tokyo 192-0152 (JP)
(72) Inventor: KABASAWA, Yasunari, Hachioji-shi Tokyo 192-0152 (JP); OOKA, Jiro, Hachioji-shi Tokyo 192-0152 (JP)
(74) Representative: Grünecker, Kinkeldey, Stockmair & Schwanhäusser
(86) International application number: PCT/JP2010/005658
(87) International publication number: WO 2011/121680

(57) **Abstract**

Disclosed is a flowrate sensor having a flowrate detection means built into a surface mounted package. The flowrate sensor includes a fluid flow path (70) formed in a package (12) to guide a fluid from an inflow port (30) provided in the lower surface of the package (12) to an outflow port (32) provided in the lower surface of the package (12) through the flowrate detection means; and an external terminal (40) provided in the outer surface of the package (12) to guide an electric output of the flowrate detection means therethrough. The flowrate sensor can be used for any of a liquid and a gas. The flowrate sensor is suitable for miniaturization, can be surface-mounted on an electronic circuit board or the like, and has a high reliability.

## Description

### Technical Field

This invention relates to a flowrate sensor in which an MEMS sensor chip is disposed in a surface mounting type package and a flowrate of a gas or a liquid can be detected, and also relates to a flowrate detection device using this flowrate sensor.

### Background Art

In recent years, there has widely been used a micro electro mechanical systems (MEMS) technology in which a semiconductor manufacturing process technology is utilized and combined with a mechanical processing technology, a material technology and the like, to realize a system having a three-dimensional fine structure on a substrate, for the purpose of the miniaturizing or lightening of a device such as a sensor or a pump. As a sensor using this MEMS technology (the MEMS sensor), for example, an acceleration sensor, an angular speed sensor, a pressure sensor or the like has widely been used.

During recent years, as a household (single-family housing) distributed type energy plant, a fuel cell system has been expected to be spread and commercialized. In this type of fuel cell, it is necessary to precisely detect and then control a flowrate of a fuel gas or a liquid fuel, an amount of water to be supplied to a reformer, and a flowrate at which hydrogen formed in the reformer or the like is supplied to the fuel cell itself. Moreover, during the reforming process in which required hydrogen (H₂) is taken from the fuel, carbon monoxide (CO) is generated, but this carbon monoxide adversely affects the performance of a cell catalyst. Hence, to decrease a carbon monoxide level, the airflow control for selective oxidation is also required at the same time. Furthermore, also in the fields of an analysis device, medical services (medication, clinical testing, etc.) and a transport machine as typified by a car, it is necessary to detect the flowrate of a micro amount of the gas or liquid. Various flowmeters have heretofore been proposed, but most of the flowmeters measure only the flowrate of the gas. There are very few flowmeters suited for the measurement of the flowrate of the liquid.

Examples of the flowmeter include an orifice flowmeter in which a fluid is passed through an orifice to detect a difference between pressures before and after the orifice by a manometer or two pressure sensors, and a turbine flowmeter in which an impeller is provided in the flow of a fluid to detect the flowrate from a rotating speed of this impeller, but each of the flowmeters has a defect that the flowmeter enlarges. Moreover, There are flowmeters known as an ultrasonic flowmeter in which an ultrasonic wave emitted obliquely from an inner wall of a flow path to a fluid flow is detected by an ultrasonic sensor provided on the facing inner wall to detect a fluid flowrate from a change of detection intensity due to a Doppler effect at that time, an electromagnetic flowmeter which detects a voltage change in a magnetic orthogonal direction generated in a fluid passing through a magnetic field, and a heat system mass flowmeter which detects a change of a temperature of a fluid before and after the fluid is heated with a heater.

Patent Document 1 and Patent Document 2 disclose that semiconductor sensors having MEMS chips constitute an acceleration sensor, an angular speed sensor and a pressure sensor, but these documents do not disclose any flowrate sensor. Patent Document 3 discloses a heat system mass flowmeter (a heat system flow sensor) in which MEMS chips formed on a silicon (Si) substrate are brought into contact with glass tubes having a micro size, thereby allowing a liquid to flow through the glass tubes.

Patent Document 4 discloses a concept of a differential pressure system flowrate sensor. More specifically, a membrane (also referred to as a diaphragm) is formed, by an etching technology, on a silicon (Si) substrate using a semiconductor fine processing technology. A fluid is passed through an aperture (at least one opening) formed in this membrane to generate a differential pressure which is proportional to a flowrate. And a stress (a strain) generated in the membrane owing to this differential pressure is electrically detected by a diffusion resistor (a piezoresistive element) formed in the membrane. A monocrystal silicon is not plastically deformed at room temperature, and hence characteristics thereof do not change. Moreover, the membrane is formed integrally with the substrate, so that stable characteristics can be obtained.

### Prior Art Documents

### Patent Documents

[Patent Document 1] JP-A-2010-28025
[Patent Document 2] JP-A-2010-19693
[Patent Document 3] US6813944B2
[Patent Document 4] US6253605B1

### Disclosure of the Invention

### Problems to be Solved by the Invention

The sensors of Patent Documents 1 and 2 detect an acceleration, an angular speed and a pressure using of MEMS technology, but do not detect a flowrate of a gas or a liquid, and do not suggest any flowmeter. In the sensor of Patent Document 3, a liquid flowing through a micro tube is heated with a heater, and hence for the purpose of improving a response, it is necessary to excessively decrease a thickness of the micro tube, thereby causing a strength problem. Moreover, when a liquid having a low boiling point is measured, bubbles are easily generated in the vicinity of the heater, thereby causing a problem that correct detection cannot be performed.

Patent Document 4 merely discloses a principle to detect a flowrate from a strain of a membrane, and does not disclose how this principle is to be used in an actual sensor. That is, in a household fuel cell system, a fuel cell for a portable device, a medical equipment and the like, the miniaturization of a flowrate sensor and especially the ease of the mounting of the sensor on an electric circuit substrate or the like are demanded, and the sensor is requested to be usable for any of a liquid and a gas and to have a high reliability, but this Patent Document 4 cannot answer such a request.

The present invention has been developed in view of such a situation, and a first object thereof is to provide a flowrate sensor which can be used for both a liquid and a gas, is suitable for miniaturization, can be surface-mounted on an electronic circuit substrate or the like and has a high reliability. Moreover, a second object thereof is to provide a flowrate detection device which enables the measurement of a large flow of a fluid by use of this flow sensor.

### Means of Solving the Problems

According to the present invention, the first object is achieved by a flowrate sensor having flowrate detection means built in a surface mounted package, including a fluid flow path formed in the package to guide a fluid from an inflow port provided in the lower surface of the package to an outflow port provided in the lower surface of the package passing through the flowrate detection means; and an external terminal provided in the outer surface of the package to guide an electric output of the flowrate detection means therethrough.

In the present invention, for the sake of convenience in description, the surface provided with the inflow port and the outflow port is the lower surface, but if the upper and lower surfaces of the package are turned upside down, this lower surface becomes the upper surface, and hence the surface may substantially be any of the upper and lower surfaces. In any case, the ports may be provided in any surface as long as the surface faces an object (an electronic circuit substrate or the like) on which this sensor is to be mounted. The external terminal may be provided in any portion on the outer surface of the package. For example, an electrode terminal such as a component provided with a lead wire or a chip component without the lead wire may be provided on the side surface, or an electrode terminal such as a ball grid array (BGA) may be provided on the lower surface.

The flowrate detection means is suitably a differential pressure type sensor including a membrane (a diaphragm) which is displaced on the basis of a pressure difference between an upstream side and a downstream side of an aperture (an opening or an orifice) provided halfway in a fluid passage to serve as a flow resistance, to detect a flowrate from the displacement of the membrane. One or a plurality of apertures may be provided in the membrane. When the one aperture is provided, the aperture may be provided in the center of the membrane. This is because when four resistors form a bridge circuit as described later, the respective resistors are easily balanced.

The flowrate detection means may be a sensor chip as an MEMS sensor including a membrane and a resistor element which becomes a strain gauge fixed to this membrane. In this case, a thin membrane is formed in part (the center) of a silicon (Si) substrate by etching, and in this membrane, the resistor element or a circuit pattern (an internal circuit pattern) can be formed by a photolithography technology or the like. That is, this sensor chip is formed by using a known semiconductor technology.

In the package, a lower substrate and an upper substrate may be superimposed to hold the peripheral edge of the sensor chip between these substrates, and an inflow port of the fluid flow path may be open in the lower surface of the membrane, thereby allowing the fluid flow path formed in the upper substrate to communicate with the outflow port through the upper surface of the membrane. With such an arrangement, the fluid flow path on an inflow port side has the smallest length, and the fluid flow path may substantially be formed only in the upper substrate, which simplifies processing. It is to be noted that the inflow port and the outflow port is replaceable with each other.

The membrane is formed to be thin by etching the inside of the sensor chip while the periphery of the sensor chip is left to be non-etched, and a resistor which becomes a strain gauge is formed on one surface (e.g., the upper surface) of this membrane. It is to be noted that this resistor is coated with an insulating film. In this case, the peripheral edge of the sensor chip becomes thick, and hence this edge may be sandwiched and held between the upper substrate and the lower substrate. During assembling, any unnecessary stress is not applied to the membrane, and characteristics become stable, which is also convenient for the assembling.

The membrane is formed into a quadrangular shape, and four resistors are arranged around the centers of sides. In this case, when the respective resistors constitute a wheatstone bridge, conditions of the resistors are conveniently satisfied. The lower surface of the upper substrate is provided with a vertical wall (a ridge or a projecting wall) which surrounds the periphery of the membrane and faces the upper surface of this membrane with a gap being left therebetween, and this upper substrate can be provided with a window for supplying an adhesive to the gap (a filling port). The adhesive for use in this case is a perfluoro adhesive having thixotropic characteristics, and this adhesive can be allowed to flow into the gap by a capillary phenomenon.

When this adhesive is provided with a flow velocity, the adhesive has a small viscosity and excellent fluidity, and when the adhesive is not provided with the flow velocity, the adhesive has a high viscosity, whereby the adhesive has characteristics (thixotropic characteristics). Therefore, when the adhesive is poured, any unnecessary stress is not applied to the membrane, but the adhesive flows automatically with the flow velocity by a capillary force, smoothly flows into the gap and is sealed. After the adhesive fills the gap, the flow velocity is eliminated, and hence the viscosity of the adhesive becomes high, whereby any unnecessary adhesive does not flow outwardly onto the membrane.

The fluid flow path formed in the upper substrate can be formed between the upper substrate and a lid plate superimposed on this substrate. For example, when a recess groove is formed in the upper surface of the upper substrate and this recess groove is covered with the lid plate, the fluid flow path can be formed by simple processing.

In the sensor chip, there is formed an internal circuit pattern which connects the resistor provided in the membrane to constitute the strain gauge to a pad formed on an outer peripheral side from projections of the upper substrate. Also, an external circuit pattern is formed in the lower substrate to connect to the external terminal. And the internal circuit pattern may be connected to the external circuit pattern by wire bonding. To this wire bonding portion, another adhesive is supplied through the window of the upper substrate after the thixotropic adhesive supplied to the gap is cured, whereby the wire bonding portion is suitably protected, and durability especially against vibration is suitably enhanced.

As described above, the external terminal is a terminal formed by metal plating into such a shape as to extend along the side surface of the lower substrate or from the side surface of the lower substrate to the lower surface thereof, in the same manner as in the chip component without the lead wire (the surface mounting type capacitor, resistor or the like). Moreover, a lead frame which is a metal plate having all external circuit patterns formed thereon is projected from the outer surface of the package, and this projecting portion may be used as the external terminal.

A second object of the present invention is achieved by a flowrate detection device using the flowrate sensor of claim 1 and characterized by comprising a main tube member to which a package of the flowrate sensor is fixed and which forms a main flow path of a fluid, and a branched flow path which distributes the fluid from this main tube member to guide the fluid to an inflow port of the flowrate sensor and which guides the fluid to the main flow path of the main tube member through an outflow port of the flowrate sensor.

In the flowrate detection device of the present invention, when flow path sectional areas of the main flow path and the branched flow path are appropriately selected, a diversion ration of the branched flow can appropriately be determined. The device can be provided with a structure in which the branch flow path is formed by using first and second sub-tube members which (e.g., orthogonally) intersect with the main flow path and which communicate with the inflow port and the outflow port of the flowrate sensor, respectively, the first sub-tube member is provided with an opening directed in an upstream direction of the main flow path, and the second sub-tube member is provided with an opening directed in a downstream direction of the main flow path. In this case, an influence of a dynamic pressure of the fluid on the flowrate sensor can be prevented or suppressed. Here, a plurality of openings may be formed. The openings may be slits.

To the main tube member, there is fixed a control substrate on which the flowrate sensor and control circuit components of the sensor are mounted, and the first and second sub-tube members penetrate through this control substrate and can be connected to the inflow port and the outflow port of the flowrate sensor. For example, when an amplification circuit which performs gain regulation or offset voltage regulation to set an output voltage of a strain gauge (a resistor) is mounted on the control substrate, an output signal of the strain gauge is not easily influenced by noises of a wiring line, which suitably enhances detection precision.

### Effect of the Invention

In a first aspect of the present invention, a flowrate detection sensor is disposed in a package, and hence the sensor can be miniaturized, to enhance a reliability. Moreover, in the package, a fluid flow path is provided, and both an inflow port and an outflow port of this fluid flow path are provided together in one surface (the lower surface) of the package, whereby the connection of the fluid flow path to a mounting object such as an electric circuit substrate can be shortened and made compact, thereby enabling highly dense mounting. Furthermore, an external terminal is provided on the outer surface of the package, and hence the package can be surface-mounted, which is suitable for higher densely mounting.

Moreover, in a flowrate detection device according to a second aspect of the present invention, this package of the flowrate sensor is fixed to a main tube member which is a main flow path of a fluid, and the fluid is distributed from this main tube member, guided to the inflow port of the flowrate sensor and returned to the main flow path through the outflow port of the flowrate sensor, so that it is possible to detect a flowrate of the fluid having a large flowrate.

### Brief Description of the Drawings

FIG. 1 is a perspective view showing an upper surface side of a flowrate sensor according to an embodiment of the present invention;
FIG. 2 is a perspective view showing a bottom surface side of the flowrate sensor shown in FIG. 1;
FIG. 3 is an exploded perspective view of the flowrate sensor shown in FIG. 1;
FIG. 4 is a side sectional view of the flowrate sensor shown in FIG. 1, and a sectional view taken along the line IV-IV along a straight line 34 in FIG. 3;
FIG. 5 is a perspective view showing a state where a sensor chip as flowrate detection means is fixed to a lower substrate;
FIG. 6 is a perspective view showing a state where an upper substrate is stacked on the lower substrate;
FIG. 7 is an enlarged sectional view of a VII arrow part in FIG. 4;
FIG. 8 is a plan view showing a circuit pattern of the sensor chip;
FIG. 9 is a diagram showing a wheatstone bridge connection circuit formed by using resistor elements of FIG. 8;
FIG. 10 is a perspective view of an embodiment of a flowrate detection device according to the present invention;
FIG. 11 is a sectional perspective view of the flowrate detection device of FIG. 10 cut along the center line of a main tube member; and
FIG. 12 is a sectional left side view of the flowrate detection device of FIG. 10 cut along the center line of the main tube member.

### Mode for Carrying Out the Invention

Hereinafter, an embodiment of the present invention will be described in detail with reference to the drawing. It is to be noted that in the following description, if necessary, terms indicating specific directions or positions (e.g., "upper", "lower", "right", "left" and the other terms including these terms) are used, but the terms are used to facilitate the understanding of the invention with reference to the drawing, and the meanings of the terms do not limit any technical scope of the present invention. Moreover, parts denoted with the same reference numerals in a plurality of diagrams indicate the same parts or members.

### Embodiment 1

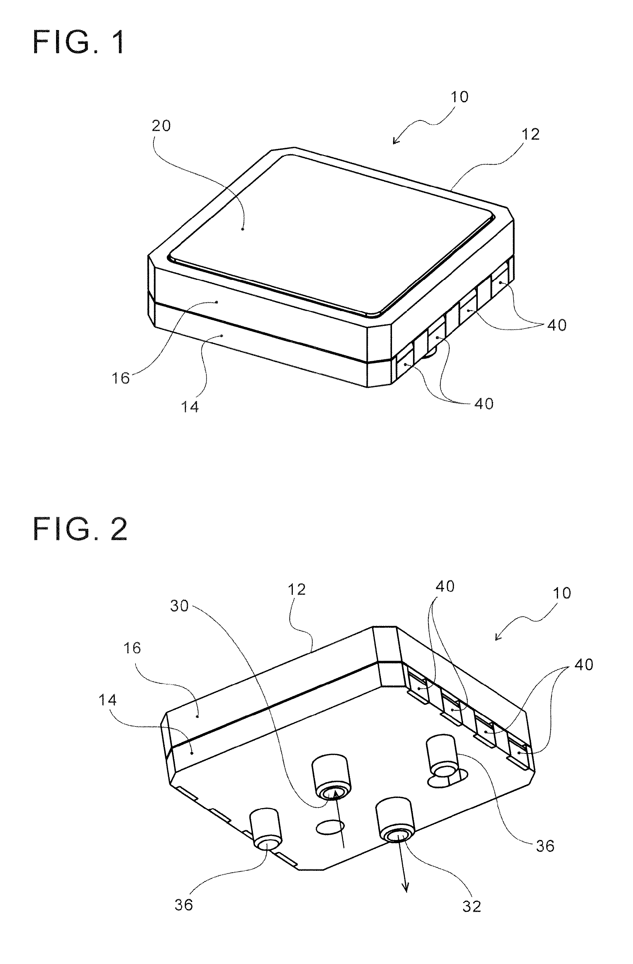

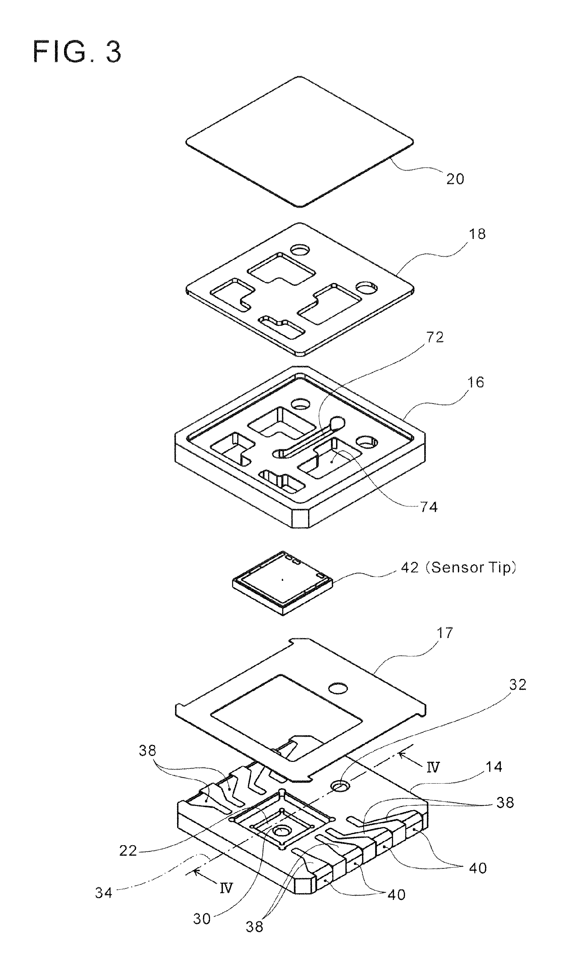

In FIGS. 1 to 4, reference numeral 10 denotes a flowrate sensor which is contained in a surface mounting type package 12. The package 12 has four sides each having a small size of about 8 mm, and as shown in FIG. 3, a lower substrate 14, an upper substrate 16, a lid plate 18 and a faceplate 20 are laminated and secured. The lower substrate 14, the upper substrate 16 and the lid plate 18 are made of a hard resin.

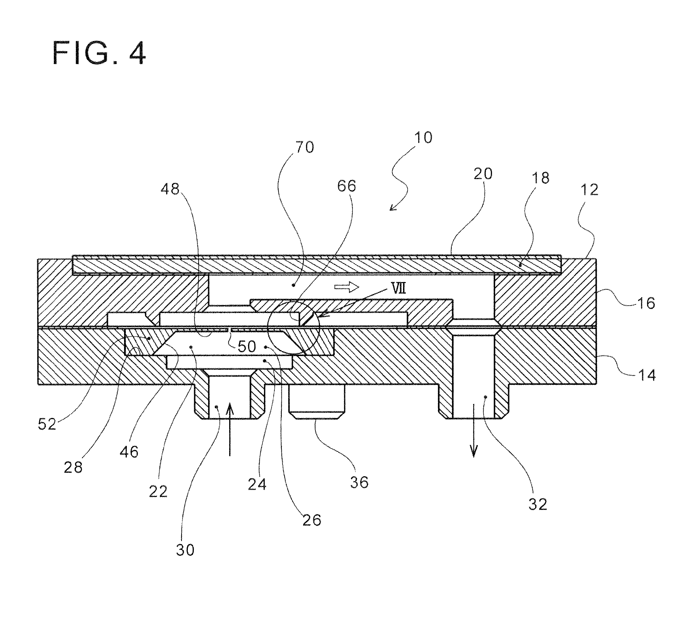

In the upper surface of the lower substrate 14, as apparent from FIGS. 3 and 4, a sensor chip containing chamber 22 having a quadrangular shape as seen in a planar view is formed at a position which is eccentric from the center on one side. The containing chamber 22 has a quadrangular shape in which a length of each side of a bottom part 24 is smaller than that of an upper part 26, and two rectangular shapes are superimposed around the same center via a horizontal step portion 28. Onto the step portion 28, a sensor chip 42 described later is secured.

In the center of the bottom of the containing chamber 22, an inflow port 30 which is part of a fluid flow path is open. The lower end of the inflow port 30 is open in the lower surface of the lower substrate 14 (see FIG. 4). In the lower substrate 14, on an opposite side of the containing chamber 22 in an eccentric direction, an outflow port 32 is formed to be a part of the fluid flow path. Therefore, as seen in a planar view, the containing chamber 22, the inflow port 30 and the outflow port 32 are positioned on a straight line 34 (FIG. 3) which passes the center of the upper surface of the lower substrate 14. It is to be noted that in the lower surface of the lower substrate 14, a pair of dowels 36 and 36 are formed on a straight line which is orthogonal to the straight line 34 (FIG. 2 and FIG. 4). The dowels 36 are used to position the flowrate sensor 10 in a case where the sensor is mounted on an electric circuit substrate or the like.

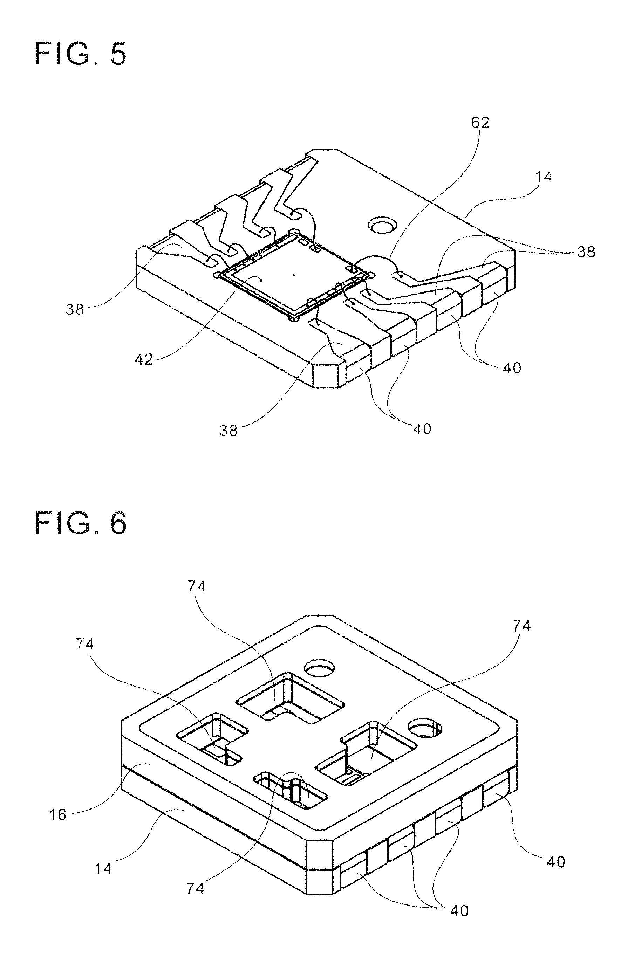

Moreover, in the lower substrate 14, a large number of (eight in FIGS. 3 and 5) external circuit patterns 38 are formed to be almost symmetric with respect to the straight line 34. The external circuit patterns 38 can be formed by a photolithography technology. Alternatively, the lower substrate 14 may be fixed with a lead frame in which the circuit patterns are beforehand formed on a metal plate by punch processing, and then removing an unnecessary part from the frame, so asto form the circuit patterns 38. In the external circuit patterns 38, one end (an inner end) of each external circuit pattern extends around the containing part 22, while the other end (an outer end) of the pattern extends along the right/left side surface of the lower substrate 14 to the lower surface of the lower substrate 14. Portions of the patterns on these side surfaces are external terminals 40 of the flowrate sensor 10.

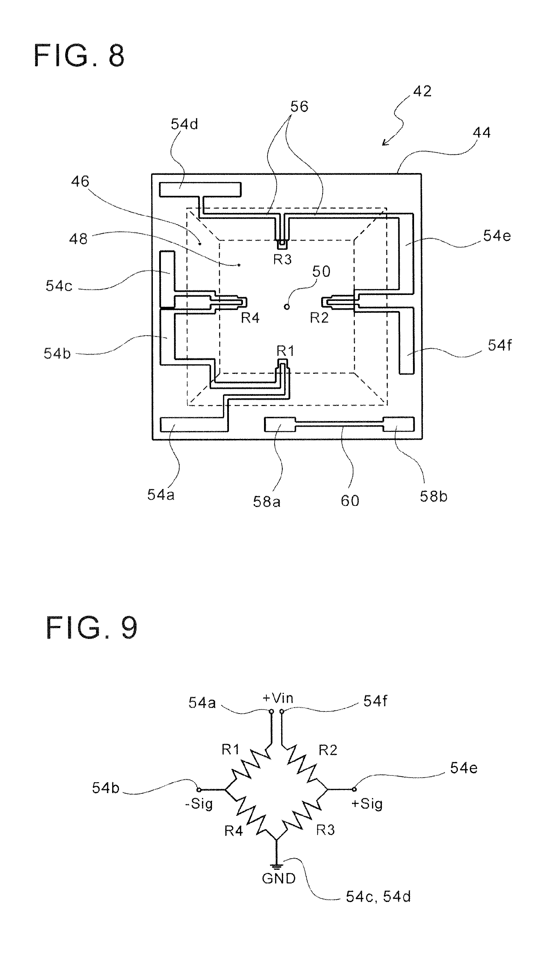

Next, the sensor chip 42 as the flowrate detection means of the present invention will be described with reference to FIGS. 4 and 8. The sensor chip 42 is formed on a silicon (Si) substrate 44 with four sides each having a size of about 3 mm by use of a semiconductor manufacturing step. The Si substrate 44 of a silicon monocrystal is a flat plate having such a dimension that the substrate can be disposed in the containing part 22 of the lower substrate 14, and in the center of the lower surface of the substrate, a thin membrane 48 surrounded with a quadrangular conical surface 46 is formed. The membrane 48 can be formed by known etching such as inductive coupling plasma (ICP) or reactive ion etching (RIE). In the center of the membrane 48, an opening 50 which is an aperture is formed. The opening 50 can similarly be formed by etching or laser processing. A diameter of the opening 50 may be changed in accordance with a measurement range or a fluid type (a liquid, a gas or the like), but the diameter is set to 50 micrometers in this example.

It is to be noted that a dot line shown in FIG. 8 indicates the quadrangular conical surface 46 formed in the outer periphery of the membrane 48, and the outside of the quadrangular conical surface 46 is a peripheral portion 52 shown in FIG. 4. The peripheral portion 52 is part of the silicon substrate 44 which is not etched and remains to be thick.

In the upper surface of the silicon substrate 44 including the formed membrane 48, there are disposed four resistor elements (strain gauges) R1 to R4, a number of (six) pads (electrodes) 54 (54a to 54f) formed along the outer peripheral edge, and internal circuit patterns 56 connecting these components (FIGS. 8 and 9). These components can be formed by using a semiconductor manufacturing technology such as photolithography. It is to be noted that as shown in FIG. 8, the resistors R1 to R4 are positioned slightly on an inner side from the center of each side of the quadrangular membrane 48 in a planar view, and the circuit patterns 56 extend from the resistors R1 to R4 in an outer peripheral direction and are then connected to the electrode pads 54 formed along the outer periphery of the membrane 48 (the outer periphery of the quadrangular conical surface), respectively.

In FIG. 8, reference numbers 58a and 58b are electrode pads of a temperature sensor, and a heat-sensitive resistor element 60 which is the temperature sensor is formed between these pads. In the upper surface of the sensor chip 42, insulating films of silicon nitride SiN, silicon carbide SiC or the like are formed inside the pads 54 and 58 as protective films.

The sensor chip 42 formed in this manner is received in the containing part 22 of the lower substrate 14. That is, as shown in FIGS. 3 and 4, the sensor chip is disposed in the containing part 22 from the upside, to hold the peripheral portion 52 of the silicon substrate 44 in the step portion 28 of the containing part 22. The sensor chip 42 is fixed to the containing part 22 by use of an adhesive. In this state, the electrode pads 54 and 58 of the sensor chip 42 are connected to the inner ends of the external circuit patterns 38 of the lower substrate 14 by wire bonding. That is, as shown in FIG. 5, wires 62 of gold (Au) or aluminum (Al) are connected to the electrode pads 54 and 58 and the external circuit patterns 38 by thermal pressing or ultrasonic joining.

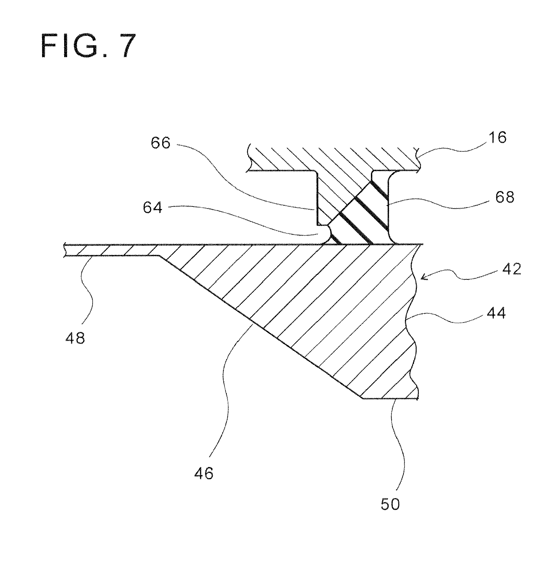

The lower surface of the upper substrate 16 (the surface which faces the lower substrate 14) is provided with a vertical wall (a projection or a ridge) 66 which faces the upper surface of the peripheral edge of the sensor chip 42 with a gap 64 being left therebetween (FIG. 7). That is, the vertical wall 66 is a hanging wall positioned above the quadrangular conical surface 46 in a planar view to surround the periphery of the membrane 48. Into the gap 64, a thixotropic adhesive 68 is allowed to flow later by using a capillary phenomenon or a surface tension. The gap 64 preferably has a size of 5 micrometers to 15 micrometers.

The upper substrate 16 is provided with a fluid flow path 70 which is open above the center of the membrane 48 and extends in parallel with the center straight line 34 (FIG. 3). The other end of the fluid flow path 70 communicates with the outflow port 32 of the lower substrate 14 (FIG. 4). The fluid flow path 70 can be formed between the upper surface of the upper substrate 16 and the lid plate 18 by closing a recess groove 72 (see FIG. 3) formed in the upper surface of the upper substrate 16 with the lid plate 18 from the upside. In this manner, the fluid flow path 70 can easily be formed horizontally to the upper substrate 16 by a semiconductor processing technology (etching or the like).

The upper substrate 16 is superimposed on the lower substrate 14 via a thermosetting adhesive sheet 17 (FIG. 3), whereby the vertical wall 66 faces the upper surface of the membrane 48 with the predetermined gap 64, and in this state, the upper substrate 16 is fixed to the lower substrate 14 with the adhesive. It is to be noted that as shown in FIGS. 3 and 6, the upper substrate 16 and the lid plate 18 are provided with four windows (filling ports) 74 opposed to the periphery of the upper surface of the sensor chip 42 from the outside of the vertical wall 66. The windows 74 are utilized to supply the thixotropic adhesive 68 to a space between the sensor chip 42 and the vertical wall 66 as described above. Moreover, after the adhesive 68 is cured, another adhesive is poured through the windows 74 to fix the wires 62.

According to this embodiment, the fluid (a gas or a liquid) flowing inwardly through the inflow port 30 flows below the membrane 48, flows through the aperture 50 of the membrane 48 to enter the fluid flow path 70, and flows outwardly through the outflow port 32. When the fluid passes through the aperture, owing to an aperture effect, a pressure difference is generated between both the surfaces of the membrane 48, whereby the membrane 48 is displaced on the upside which is a low pressure side. This displacement changes a stress to be applied to the resistors R1 to R4, thereby changing resistance values thereof. In consequence, an output of a bridge circuit shown in FIG. 9 changes. This change of the output voltage corresponds to the pressure difference applied to both the surfaces of the membrane 48. This pressure difference is proportional to the flowrate of the fluid according to Hagen-Poiseuille law, so that when this pressure difference is detected, the flowrate can be detected.

### [Embodiment 2]

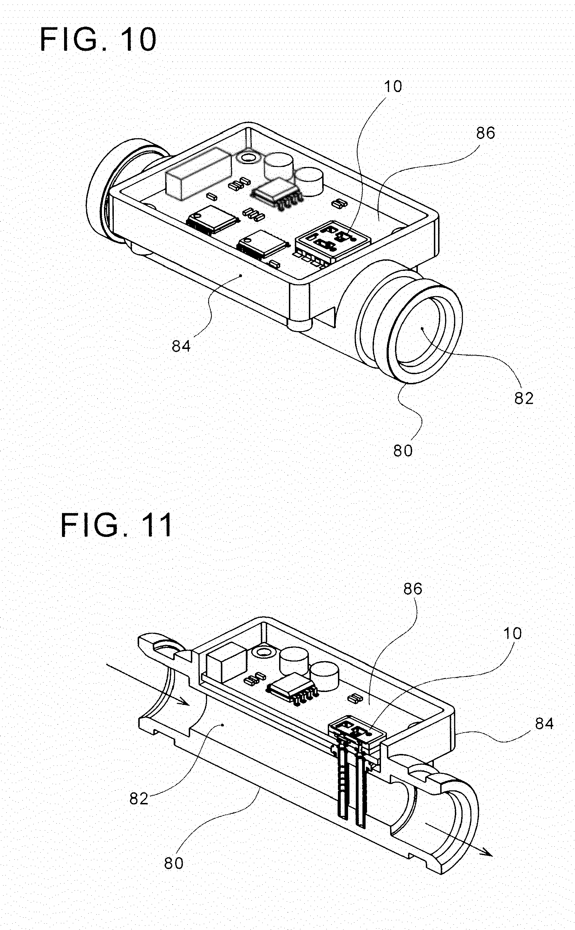

FIGS. 10 to 12 show a flowrate detection device using the flowrate sensor 10. In these diagrams, a reference numeral 80 is a main tubular member to form a main flow path 82 through which a fluid flows. A tubular wall of the main tube member 80 is integrally provided with a substrate containing part 84 formed along a length direction of the wall. In the substrate containing part 84, a control substrate 86 is received. On the upper surface of the control substrate 86, the flowrate sensor 10 and an amplification circuit of an output signal of this sensor are mounted, and if necessary, another operation circuit such as a circuit which performs gain regulation or offset voltage regulation or the like may be mounted.

The flowrate sensor 10 is fixed to this surface so that a straight line 34 (FIG. 3) passing the center of a membrane 48 is parallel to the main flow path 82 and an inflow port 30 is positioned on an upstream side of the main flow path 82 from an outflow port 32. Moreover, between the control substrate 86 and the main tube member 80, a connection member 88 positioned under the flowrate sensor 10 is interposed.

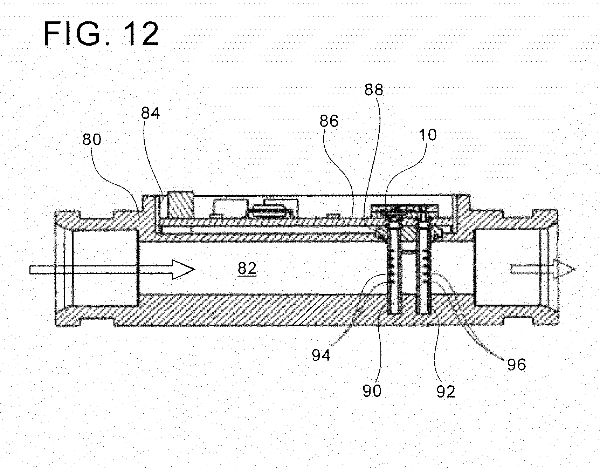

To the lower surface of the connection member 88, as shown in FIG. 12, upper ends of first and second sub-tube members 90 and 92 are fixed away from each other as much as a distance between the inflow port 30 and outflow port 32 of the flowrate sensor 10. The connection member 88 is liquid-tightly fixed to an opening made in a tubular wall of the main tube member 80, and at this time, the first and second sub-tube members 90 and 92 extend across the main flow path 82 and are fixed. The upper ends of the first and second sub-tube members 90 and 92 pass through the connection member 88, and are further liquid-tightly connected to the inflow port 30 and the outflow port 32 of the flowrate sensor 10 via openings provided in the control substrate 86.

The first sub-tube member 90 is provided with a plurality of slits 94 as openings directed in an upstream direction of a fluid, and the second sub-tube member 92 is provided with a plurality of slits 96 as openings directed in a downstream direction of the fluid. In consequence, part of a fluid flow of the main flow path 82 is divided via the sub-tube members 90 and 92 which are branch flow paths, to flow into the flowrate sensor 10. The flowrate sensor 10 detects a flowrate of a branch flow through these branch flow paths, and can specify the whole flowrate through the main tube member 80.

On the control substrate 86, together with the signal amplification circuit of the flowrate sensor 10, there can be mounted an adequate circuit such as the operation circuit which performs an arithmetic operation for correcting an output of the flowrate sensor 10 by such a branched flow ratio between the main flow path 82 and the branch flow paths to obtain the flowrate of the main flow path 82, or a temperature correction circuit.

### Description of Reference Numerals

- 10: flowrate sensor
- 12: package
- 14: lower substrate
- 16: upper substrate
- 18: lid plate
- 22: sensor chip containing part
- 30: inflow port (part of fluid flow path)
- 32: outflow port (part of fluid flow path)
- 34: straight line passing upper surface center of lower substrate
- 38: external circuit pattern
- 40: external terminal
- 42: sensor chip (flowrate detection means)
- 44: silicon substrate
- 48: membrane
- 50: aperture (opening)
- 54 and 58: electrode pad
- 56: internal circuit pattern
- 62: wire
- 64: gap
- 66: vertical wall
- 68: thixotropic adhesive
- 70: fluid flow path
- 74: window (adhesive pouring port)
- 80: main tube member
- 82: main flow path
- 86: control substrate
- 88: connection member
- 90: first sub-tube member (branch flow path)
- 92: second sub-tube member (branch flow path)
- 94: and 96 opening (slit)
- R1, R2, R3 and R4: resistor element (strain gauge or resistor)

## Claims

1. A flowrate sensor having flowrate detection means built into a surface mounted package, comprising:
a fluid flow path formed in the package to guide a fluid from an inflow port provided in the lower surface of the package to an outflow port provided in the lower surface of the package through the flowrate detection means; and
an external terminal provided in the outer surface of the package to guide an electric output of the flowrate detection means therethrough.

2. The flowrate sensor according to claim 1, wherein the flowrate detection means is a differential pressure type sensor including a membrane which is displaced on the basis of a pressure difference between an upstream side and a downstream side of an aperture provided halfway in the fluid flow path, to detect a flowrate from the displacement of the membrane.

3. The flowrate sensor according to claim 2, wherein the flowrate detection means is an MEMS sensor formed by using a sensor chip including the membrane and a strain gauge fixed to this membrane to detect a strain generated in accordance with the displacement of the membrane.

4. The flowrate sensor according to claim 3, wherein the package comprises a lower substrate having a lower surface in which the inflow port and the outflow port are open, and an upper substrate superimposed on this lower substrate to hold a peripheral portion of the sensor chip between the upper substrate and the lower substrate, the inflow port is open in the lower surface of the membrane, and the upper surface of the membrane communicates with the outflow port through the fluid flow path formed in the upper substrate.

5. The flowrate sensor according to claim 4, wherein the membrane is formed to be thin by etching the inside of the sensor chip while the peripheral portion of the sensor chip remains to be non-etched, and one surface of the membrane is provided with a resistor serving as the strain gauge.

6. The flowrate sensor according to claim 5, wherein the membrane has a quadrangular shape, four resistors constituting the strain gauge are arranged in the centers of sides of the membrane, and the respective resistors form a bridge circuit.

7. The flowrate sensor according to claim 4, wherein the lower surface of the upper substrate is provided with a vertical wall which surrounds the periphery of the membrane and which faces the upper surface of the membrane with a gap being left therebetween, and this upper substrate is provided with a window through which an adhesive is supplied to the gap.

8. The flowrate sensor according to claim 4, wherein the fluid flow path formed in the upper substrate is formed between the upper substrate and a lid plate superimposed on the upper surface of the upper substrate.

9. The flowrate sensor according to claim 6, wherein the sensor chip is provided with an internal circuit pattern which connects the strain gauge provided on the membrane to an electrode pad formed on an outer peripheral side from the vertical wall of the upper substrate, the lower substrate is provided with an external circuit pattern connected to the external terminal, and the internal circuit pattern is connected to the external circuit pattern by wire bonding.

10. The flowrate sensor according to claim 7, wherein the adhesive supplied to the gap formed between the vertical wall of the upper substrate and the lower substrate is a perfluoro adhesive having thixotropic characteristics, and this adhesive is filled into the gap by a capillary phenomenon.

11. The flowrate sensor according to claim 7, wherein the adhesive supplied to the gap between the vertical wall of the upper substrate and the lower substrate is cured, and then another adhesive is supplied to the outside of the gap.

12. The flowrate sensor according to claim 1, wherein the external terminal is a metal plating layer formed on at least the side surface of the lower substrate.

13. The flowrate sensor according to claim 8, wherein the external terminal is formed by using a lead frame disposed integrally with the external circuit pattern.

14. A flowrate detection device which uses the flowrate sensor according to claim 1, comprising:
a main tube member to which a package of the flowrate sensor is fixed, to form a main flow path of a fluid; and
a branch flow path which distributes the fluid from this main tube member to guide the fluid to an inflow port of the flowrate sensor and which guides the fluid to the main flow path of the main tube member through an outflow port of the flowrate sensor.

15. The flowrate detection device according to claim 13, wherein the branch flow path comprises first and second sub-tube members which intersect with the main flow path to communicate with the inflow port and the outflow port of the flowrate sensor, respectively, the first sub-tube member is provided with an opening directed in an upstream direction of the main flow path, and the second sub-tube member is provided with an opening directed in a downstream direction of the main flow path.

16. The flowrate detection device according to claim 15, wherein to the main tube member, there is fixed a control substrate on which the flowrate sensor and control circuit components of the sensor are mounted, and the first and second sub-tube members penetrate through this control substrate and are communicated with the flowrate sensor.
